(19) Europäisches Patentamt
European Patent Office
Office européen des brevets

(11) **EP 2 148 445 B1**

(12) **EUROPEAN PATENT SPECIFICATION**

(45) Date of publication and mention of the grant of the patent:
**20.06.2012 Bulletin 2012/25**

(51) Int Cl.:
***H03M 13/11*** *(2006.01)*

(21) Application number: **08425494.5**

(22) Date of filing: **22.07.2008**

(54) **Generating exponent matrixes for LDPC codes**

Erzeugung von Exponentenmatrizen für LDPC-Codes

Génération de matrices exponentielles pour codes LDPC

(84) Designated Contracting States:
**AT BE BG CH CY CZ DE DK EE ES FI FR GB GR HR HU IE IS IT LI LT LU LV MC MT NL NO PL PT RO SE SI SK TR**

(43) Date of publication of application:
**27.01.2010 Bulletin 2010/04**

(73) Proprietors:
• **Nokia Siemens Networks S.p.A.**
  **20126 Milano (IT)**
• **Nokia Siemens Networks OY**
  **02610 Espoo (FI)**

(72) Inventors:
• **Cannalire, Giacomo Francesco**
  **20062 Cassano d'Adda (IT)**
• **Mazzucco, Christian**
  **20060 Milano (IT)**

(74) Representative: **Fischer, Michael**
**Nokia Siemens Networks GmbH & Co. KG**
**Intellectual Property Rights**
**P.O. Box 80 17 60**
**81617 München (DE)**

(56) References cited:
**WO-A-2008/007927     WO-A-2008/069460**
**US-A1- 2007 011 569**

• ZHICHU LIN ET AL.: "A new design method of multi-rate quasi-cyclic LDPC codes" PROC., IEEE INTERNAT. CONF. ON COMMUNICATIONS, CIRCUITS AND SYSTEMS, 1 June 2006 (2006-06-01), pages 707-711, XP031010530 ISBN: 978-0-7803-9584-8
• SHASHA E ET AL.: "Multi-Rate LDPC code for OFDMA PHY" INTERNET CITATION, [Online] XP002334837 Retrieved from the Internet: URL: http://www.ieee802.org/16/tge/contrib/ C80216e-04_185.pdf> [retrieved on 2005-07-05]
• JONG-EE OH ET AL.: "Row-splitting design of low-density parity-check codes for Gbps transmission" PROC., IEEE 66TH VEHICULAR TECHNOLOGY CONFERENCE, VTC-2007 FALL, 1 September 2007 (2007-09-01), pages 1127-1131, XP031147582 ISBN: 978-1-4244-0263-2

**Description**

The present invention relates to a method and to a system according to the preambles of claims 1, 5 and 7.

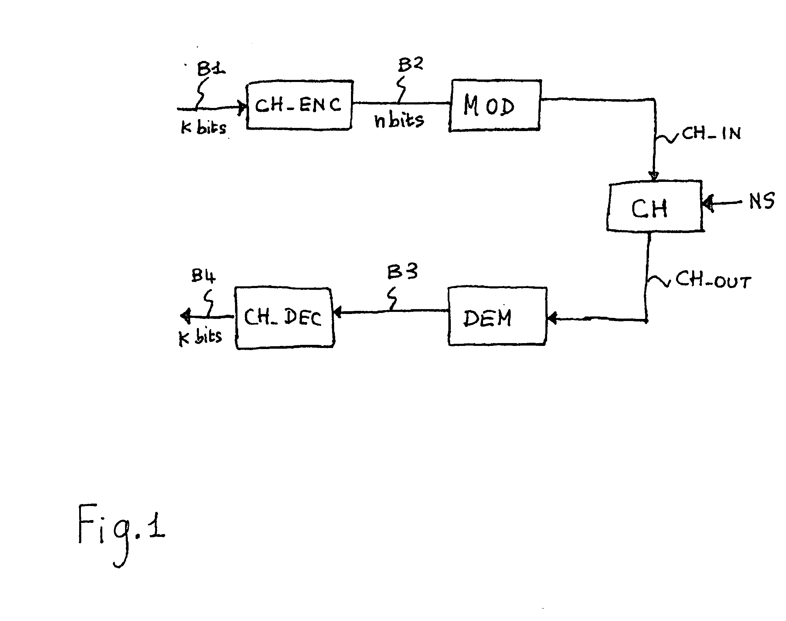

Let us consider a schematic example of a digital communication system model as the one shown in the block diagram of Figure 1.

The input of channel encoder CH_ENC is an information sequence B 1 of k bits to which a redundancy sequence of *r* bits is added thereby producing an encoded sequence B2 of *n* bits.

The channel code rate *R* is defined as the ratio between the information bits number *k* and the encoded bits number *n*, thus $R = k / n$

Modulator MOD transforms the encoded vector B2 into a modulated signal vector CH_IN which is in turn transmitted through a channel CH. Since the channel CH is usually subject to noisy disturbance NS, the channel output CH_OUT may differ from the channel input CH_IN.

At the receiving end, the channel output CH_OUT is processed by the demodulator DEM which performs the inverse operation of the modulator MOD and produces some likelihood ratio.

The channel decoder CH_DEC uses the redundancy in the received sequence B3 to correct the error in the information sequence of the received sequence B3 and produces a decoded signal B4 which is an information signal estimate.

State of the art encoder/decoder structures CH_ENC, CH_DEC use codes Low Density Parity Check (LDPC) code as proposed by the IEEE 802.16e Standard for Air Interface For Fixed and Mobile Broadband Wireless Access Systems [Ref.1].

LDPC codes are block codes. Block codes use a generator matrix *G* for the encoding operation and a parity-check matrix *H* for the decoding operation.

For a block code with information sequence of *k* bits, a codeword of *n* bits and redundancy (parity) sequence of *r=(n-k)* bits, the generator matrix *G* has *kxn* dimensions, and the parity-check matrix *H* has *rxn=(n-k)xn* dimensions.

These two matrixes enjoy the orthogonal property, which states that for any matrix $G_{kxn}$ with *k* linearly independent rows there exists a matrix $H_{rxn}$ with *r=(n-k)* linearly independent rows such that any row of $G_{kxn}$ is orthogonal to the rows of $H_{rxn}$ such that the following equation is satisfied:

$$(i)\ G_{kxn} \cdot H^T_{rxn} = 0$$

The encoding operation is performed by means of the multiplication between the information sequence $U_{1xk}$ and the code generator matrix $G_{kxn}$ The result, of such multiplication, is the encoded output sequence $V_{1xn}$ as follows:

$$(ii)\ V_{1xn} = U_{1xk} \cdot G_{kxn}$$

At the receiving side, due to the orthogonal property between matrixes $G_{kxn}$ and $H_{rxn}$, the following equation should be satisfied:

$$(iii)\ H_{rxn} \cdot B^T_{nx1} = 0$$

where $B^T_{nx1}$ is the decoded received sequence which comprises the information signal estimate B4. If equation (iii) is verified the information signal estimate B4 is correct otherwise the errors in the received sequence B3 exceed the correction capacity of the carried-out code.

Once the code generator matrix $G_{kxn}$ is built, it is possible to obtain the parity-check matrix $H_{rxn}$ and vice versa.

The proposed invention relates to both "channel encoder" and "channel decoder" of Figure 1 for LDPC codes. There are several design techniques for generating the parity-check matrix $H_{rxn}$ of a LDPC code. The most used generating technique in LDPC code design is the semi-random technique,

The parity-check matrix $H_{rxn}$ is built combining in a certain manner three matrixes: the exponent matrix $H_{exp}$ for a specific rate *R*, the seed matrix for the rate R and the spreading matrix for a given spreading factor $Z_f$. The element-by-element multiplication of the non-binary exponent matrix $H_{exp}$ with the seed matrix generates another exponent matrix E which is in turn expanded to the parity-check matrix $H_{rxn}$, hereby also called expanded matrix $H_{rxn}$, via the spreading

matrix. The spreading matrix is a square binary matrix of weight one and dimension $Z_f x Z_f$, being $Z_f$ the desired spreading factor which is tied to the codeword length of the carried-out LDPC code.

An exponent matrix is a conventional matrix representing a block structured matrix. The elements of the exponent matrix are expanded in square matrixes of dimension $Z_f x Z_f$ by applying the below rules known from the art. The same "expansion" rules apply to the exponent matrix $E$ obtained by multiplicating, element-by-element, the exponent matrix $H_{exp}$, with the seed matrix.

It is noted that the exponent matrix is typically built with the maximum spreading factor $Z_0$ which corresponds to the maximum codeword size. However, it is possible to implement codewords of variable sizes.

When a different codeword size is desired - whose size is smaller than the maximum size, a spreading factor $Z_f$ smaller than $Z_0$ is required. In such cases, it is possible to convert the exponent matrix built with maximum spreading factor $Z_0$ into an exponent matrix having spreading factor $Z_f < Z_0$ by using some translation formulas as, for example, the formula reported in IEEE 802.16e Standard [Ref.1] on page 627 , relation (129a).

The exponent matrix elements with values comprised between $0$ and $(Z_f-1)$ represent permutation matrixes of the identity matrix (with weight equal to "1" for each row and for each column) with dimensions $Z_f x Z_f$. The value of the exponent matrix element indicates the cyclic shift to the right of the identity matrix, as shown in the matrixes $I_{Z_f}^{[0]}$, $I_{Z_f}^{[1]}, ..., I_{Z_f}^{[Z_f-1]}$ below.

All non-negative exponent matrix elements have meaning, for example the zero exponent permutation matrix corresponds to the identity matrix.

$$I_{Z_f}^{[0]} = \begin{bmatrix} 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \end{bmatrix} \qquad I_{Z_f}^{[1]} = \begin{bmatrix} 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \\ 0 & 0 & 0 & 0 & . & 0 & 0 & 1 \\ 1 & 0 & 0 & 0 & . & 0 & 0 & 0 \end{bmatrix}$$

$$I_{Z_f}^{[Z_f-1]} = \begin{bmatrix} 0 & 0 & 0 & 0 & . & 0 & 0 & 1 \\ 1 & 0 & 0 & 0 & . & 0 & 0 & 0 \\ 0 & 1 & 0 & 0 & . & 0 & 0 & 0 \\ 0 & 0 & 1 & 0 & . & 0 & 0 & 0 \\ 0 & 0 & 0 & 1 & . & 0 & 0 & 0 \\ . & . & . & . & . & . & . & . \\ 0 & 0 & 0 & 0 & . & 1 & 0 & 0 \\ 0 & 0 & 0 & 0 & . & 0 & 1 & 0 \end{bmatrix}$$

Each element of the exponent matrix of value "-1" conventionally represents a null square matrix of size $Z_f x Z_f$ as shown in matrix $I_{Z_f}^{[-1]}$.

$$I_{z_f}^{[-I]} = \begin{bmatrix} 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ . & . & . & . & . & . & . & . \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \\ 0 & 0 & 0 & 0 & . & 0 & 0 & 0 \end{bmatrix}$$

The skilled in the art easily understands that same benefits may be obtained if the cyclic shift is a cyclic shift to the left instead than a one to the right.

It is noted that the term "exponent matrix" is an expression widely used in the art to conventionally denote a matrix whose elements, also called "exponents", represent permutation matrixes of the identity matrix with the given exponent.
Sometimes in the art, the term "exponent" used for the elements of the exponent matrix may be replaced with the equivalent term "shift-size".

Hence, the expanded matrix $H_{rxn}$ is obtained by the above outlined expansion of the exponent matrix $E$ When realized with semi-random technique, the expanded matrix $H_{rxn}$, is constituted of two sub-matrixes: the first sub-matrix is a random matrix having $(n-k)xk = rxk$ size and the second one is a semi-deterministic sub-matrix of $(n-k)x(n-k) = rxr$ size.

The exponent matrix $H_{exp}$ is used in the implementation of both LDPC encoder and LDPC decoder. In the LDPC encoding operation, Method 2 , shown in standard IEEE 802.16e [Ref.1], allows to reduce the LDPC encoder hardware complexity if the exponent matrix $H_{exp}$ is split in opportune sub-matrixes, a random one and a semi-deterministic one: the semi-determininistic sub-matrix is itself split into a semi-deterministic column vector $Cv$, its first column vector which is constructed in an opportune way, and a deterministic matrix which is typically a bi-diagonal matrix as known from the art.

The Method 2 imposes that the column vector Cv has only three elements different from "-1", representing the null matrix, that the first and the last element are equal and that only one randomly chosen element is equal to "0", representing the identity matrix.

Unfortunately in state of the art LDPC codes, for each code rate $R$, a rate-specific exponent matrix $H_{exp}$ or $E$ is dedicated.

The fact that for each code rate $R$ a specific exponent matrix has to be stored has the drawback of impacting the hardware requirements for the storage of all the necessary exponent matrixes.

It is therefore the aim of the present invention to overcome the above mentioned drawbacks, in particular by providing a method and a system for generating exponent matrixes for LDPC codes which minimizes the storage requirements for exponent matrixes of different code-rates.

State of the art with regard to this topic may be the document US 2007/011569 A1 (Vila Casado Andres et al, "Variable-Rate Low-Density Parity Check Codes with Constant Blocklength"). It describes a method for designing LDPCCs for a variety of different rates that all share the same fundamental encoder/decoder architecture.

The aforementioned aim is achieved by a method and a system for generating a multi-rate table for generating exponent matrixes for LDPC codes, said LDPC codes supporting different block sizes for each code rate $R_j$ and being implemented with semi-random technique which requires that the exponent matrixes are composed of two sub-matrixes, a random sub-matrix and a semi-deterministic sub-matrix, wherein, conditions on column vector $Cv$, the first column vector of the semi-deterministic matrix, require that said column vector $Cv$ has only three "non-null" elements with value different from "-1", which conventionally represents a null matrix, two of said three "non-null" elements being the first and the last element of the column vector $Cv$ and the third "non-null" element being in a random position and having value "0" which represents the identity matrix, the invention:

-   providing a random table having a column number $n_b$ and a row number $r_b$;
-   dedicating for each code rate $R_j$, two rows of the random table to be processed;
-   generating the multi-rate table from said random table, by processing the elements of the two dedicated rows so as to satisfy said conditions on said column vector $Cv$.

In the invention, the column number $n_b$ may preferably be computed as $n_b=n_0/z_0$ being $n_0$ the maximum codeword length and being $Z_0$ the highest spreading factor.

In the invention, for each code-rate $R_j$, the choice of the two dedicated rows may advantageously comprise the following step:

- choosing the first dedicated row as being row $r_j$ where $r_j$ is computed as $r_j=n_b.(1-R_j)$
- choosing the second dedicated row randomly among the non-dedicated available rows between the first row and row $r_j$ excluded.

In the invention, the elements of the two dedicated rows may conveniently be processed according to the following steps:

- adding to each element of the first dedicated row $r_j$ a value so that, after a "mod" operation, the first and the last value of the column vector $Cv$ are identical
- adding to the each element of the second dedicated row a value so that, after a "mod" operation, the randomly chosen element in column vector $Cv$ has value "0".

The aforementioned aim is achieved by a method and a system for generating for generating an exponent matrix of rate $R_j$ for LDPC codes, departing from the multi-rate table generated with the above proposed invention, wherein the exponent matrix for code-rate $R_j$ has dimensions $r_j x n_j$ and it is composed of two sub-matrixes, a random sub-matrix of dimensions $r_j x (n_j - r_j)$ and a semi-deterministic sub-matrix of dimensions $r_j x r_j$, wherein:

- the random sub-matrix is generated by removing from the multi-rate table the rows with index higher that $r_j$ and the columns with index higher than $(n_j - r_j)$;
- the first column vector $Cv$ of the semi-deterministic matrix, being located at column $(n_j-r_j+1)$ of the multi-rate table, has three elements with value different than "-1", the first element and the two elements of the two dedicated rows for rate $R_f$.

In the invention, the row number $r_j$ and the column number $n_j$ of the exponent matrix for code-rate $R_j$ may preferably computed as follows: $r_j=n_b.(1-R_j)$ and $n_j=n_b$

The proposed invention allows reducing the cost of channel encoder/decoder equipments because it is necessary to store only one multi-rate table from which several exponent matrixes $H_{exp}$ can be derived for variable code-rates.

All the processing performed in the proposed invention doesn't change the characteristics of the expanded parity-check matrix of being a binary matrix with a low density or "1 ". Moreover, the processing of the proposed invention doesn't change the block structured exponent matrix characteristics because each element maintains the characteristic of unitary weight permutation matrix.

The above characteristics keep low the storage requirements and the hardware complexity the LDPC code implementation.

The invention will now be described in preferred but not exclusive embodiments with reference to the accompanying drawings, wherein:

Figure 1     is block diagram schematically illustrating a digital communication system model (Prior Art);

Figure 2     is the random part of an exponent table according to an example embodiment of the present invention;

Figure 3     is a single-rate table for code-rate $R_2$ according to the example embodiment of the present invention;

Figure 4     is a bi-rate table for code rates $R_2$, $R_1$ according to the example embodiment of the present invention;

Figure 5     is a multi-rate table for code-rates $R_2$, $R_1$, $R_0$ according to an example embodiment of the present invention;

Figure 6     is an exponent matrix for rate $R_2$ according to the example embodiment of the present invention;

### *Numerical Example*

A simple numerical example according to an embodiment of the present invention is illustrated. In this example a multi-rate exponent table is built for LDPC code implementation, for the three following rates: $R_0 =7/8$, $R_1 = 11/12$, $R_2 =15/16$ for the following spreading factors $Z_0 = 108$, $Z_1 = 81$, $Z_2 = 54$ and being the largest codeword length $n_0 =10368$.

The number of the columns $n_b$ of the multi-rate exponent table is computed from the largest codeword length $n_0$ and the highest spreading factor $Z_0$ as follows:

$$n_b = n_0 / Z_0 = 96 \qquad (1)$$

As a result, the other codeword lengths or block sizes $n_1$, $n_2$ are the following $n_1 = n_b \cdot Z_1 = 7776$ and $n_2 = n_b \cdot Z_2 = 5184$.

The LDPC code supports different block sizes for each code rate $R_0$, $R_1$, $R_2$ where the information sequence length is indicated with $k(bits)\_sequence$ as shown in Table 1 below.

Table 1

| $Z_f$ | $k(bits)\_sequence$ $R_0 = 7/8$ | $k(bits)\_sequence$ $R_1 = 11/12$ | $k(bits)\_sequence$ $R_2 = 15/16$ |
|---|---|---|---|
| 54 | 4536 | 4752 | 4860 |
| 81 | 6804 | 7128 | 7290 |
| 108 | 9072 | 9504 | 9720 |

The number of rows $r_b$ of the multi-rate table is computed from the lowest code rate $R_0 = 7/8$ and the column number $n_b$ as follows:

$$r_b = n_b \cdot (1 - R_0) = 12 \qquad (2)$$

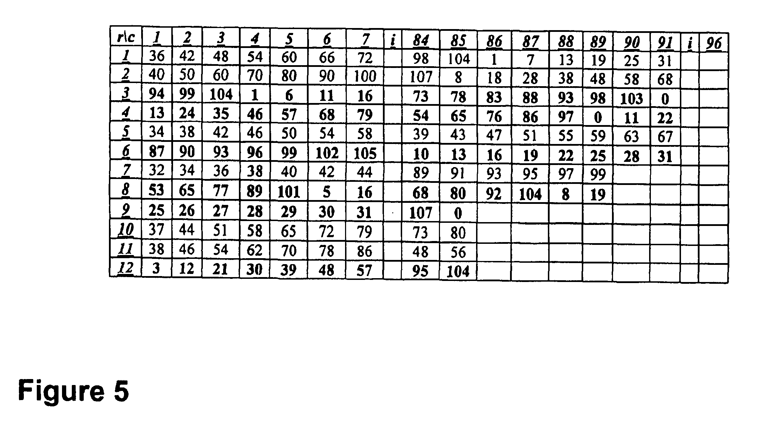

Thus, the multi-rate table to be generated according to this numerical example will have dimension $n_b x r_b$. It is noted that the multi-rate table to be generated is not a full matrix but it has a "step-like" shape as it will be illustrated below and as it can be seen in the multirate table shown in Figure 5.

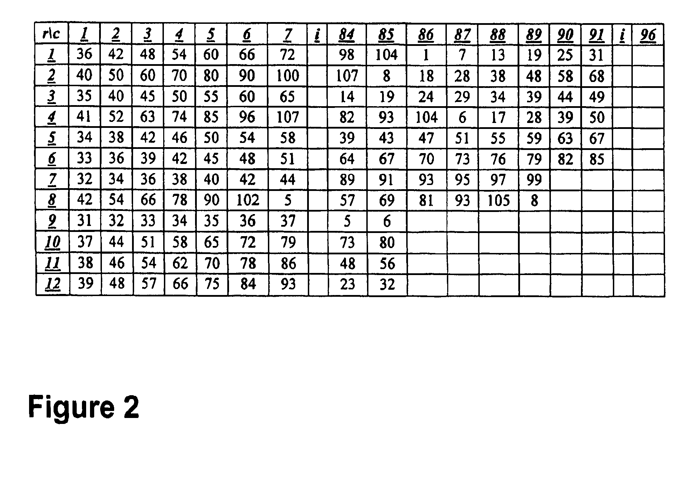

Let us assume to have a random matrix as the one shown in Figure 2. Figure 2 shows the random part of an exponent table built randomly with highest spreading factor $Z_0$. In other embodiments of the present invention the elements of the table of Figure 2 can have other values as known from the art.

In order to generate a multi-rate table according to the present invention, two rows of the table of Figure 2 are dedicated for each code rate $Rj$ and an opportune processing is performed in order to satisfy the conditions on the semi-deterministic column vector $Cv$ as below exemplified.

### Required processing for rate $R_2$

For code rate $R_2 = 15/16$, the dedicated exponent matrix has $dimensions$ $r_2 - n_b$ where $r_2 = n_b \cdot (1 - R_2) = 6$ and where $n_b = 96$. The semi-deterministic column vector $Cv$ is located at position $c_2$ where $c_2 = n_b - (r_2 - 1) = 91$

The conditions on the semi-deterministic column vector $Cv$ impose that the column vector $Cv$ has only three elements having value different from "-$1$": the first element of the column vector $Cv$, with coordinates $(1, c_2) = (1,91)$, and the last column element, with coordinates $(r_2, c_2) = (6,91)$, must be equal and only one of all the other remaining column $Cv$ elements, e.g. one of the elements with coordinates $(2, c_2)$, $(3, c_2)$, $(4, c_2)$, $(5, c_2)$, must be equal to "$0$".

Then, for LDPC code with rate $R_2 = 15/16$, the following two rows are dedicated, the sixth row $r_2$ and the third row 3, the latter being chosen in a random way between the second and the fifth rows.

- The sixth row, in mandatory way, the coordinates of the column element in the sixth row being $(r_2, c_2) = (6,91)$
- The third row chosen, in random way, between second and fifth row, the coordinates of the column element in the third row being $(3, c2) = (3,91)$

The above-mentioned two rows, after being modified by the processing described below, belong to the multi-rate exponent table and they cannot be dedicated to any of the other remaining code rates, e. g. $R_0 = 7/8$ and $R_1 = 11/12$.

The processing to be performed in the two dedicated rows is explained in terms of multiplication of unitary weight permutation matrixes, taken into account that an exponent matrix is a representation of a combination of such unitary weight permutation matrixes as previously explained.

It is noted that any multiplication operation between unitary weight permutation matrixes produces again a permutation matrix of the identity matrix.

Let us denote by $r_i$ the row which is dedicated and chosen in a mandatory way, where $r_i = n_b \cdot (1 - R_i)$, by $m$ the row which is dedicated and chosen in a random way, by $c_w$ the semi-deterministic column index and by $Z_0$ the maximum spreading factor.

In order to satisfy the conditions on the column vector $Cv$ for which element $(m, c_w)$ must be equal to element $(1, c_w)$, the matrixes represented by the elements in row $r_i$ are multiplied with the permutation matrix of the identity matrix of exponent $e_i$, calculated with equation (3a) below.

$$e_i = \mathrm{mod}\{[(1, c_w) - (r_i, c_w)], Z_0\} \tag{3a}$$

This multiplication between unitary weight permutation matrixes can be implemented by calculating $(r_i, j)$ as shown in formula (3b) which is an easy computation.

$$(r_i, j) = \mathrm{mod}\{[e_i + (r_i, j)], Z_0\} \qquad \text{with} \quad j = 1, 2, 3, \ldots\ldots, c_w \quad \text{column number} \tag{3b}$$

In order to satisfy the conditions on the column vector $Cv$ for which element $(m, c_w)$ must be equal to zero, representing the identity matrix, the matrixes represented by the elements of the $m\text{-}th$ row are multiplied by the permutation matrix of the identity matrix of exponent $e_m$ calculated with equation (4a) below.

$$e_m = \mathrm{mod}\{[0 - (m, c_w)], Z_0\} \tag{4a}$$

This multiplication between unitary weight permutation matrixes can be implemented by calculating $(m, j)$ as shown in formula (4b) which is an easy computation.

$$(m, j) = \mathrm{mod}\{[e_m + (m, j)], Z_0\} \qquad \text{with} \quad j = 1, 2, 3, \ldots\ldots, c_w \quad \text{column number}$$

$$(4b)$$

In order to satisfy the conditions on the column vector $Cv$ for which element $(r_2, c_2) = (6,91)$ must be equal to element $(1, c_2) = (1,91)$, the matrixes represented by the elements of the sixth row $r_2$ are multiplied with the permutation matrix of the identity matrix of exponent $e_6 = 54$ as shown below:

$$e_6 = \mathrm{mod}\{[(1, c_2) - (r_2, c_2)], Z_0\} = \mathrm{mod}\{[31 - 85], 108\} = 54$$

where with $e_6$ is indicated the exponent of the permutation matrix which multiplies all matrixes represented by the elements in the dedicated row $r_2 = 6$ of the table in Figure 2. This multiplication is implemented by performing the following calculation in row $r_2 = 6$ :

$(r_2, j) = \mathrm{mod}\{[e_6 + (r_2, j)], Z_0\} = \mathrm{mod}\{[54 + (r_2, j)], 108\}$ where with $j = 1, 2, 3, \ldots\ldots, 90, 91$ is indicated the column index.

In order to impose the condition of having the element $(3, c_2) = (3,91)$ equal to zero (identity matrix), the matrixes represented by the elements of the third row are multiplied by the permutation matrix of the identity matrix of exponent 59 as shown below:

$$e_3 = \mod\{[0 - (3, c_2)], Z_0\} = \mod\{[0 - 49], 108\} = 59$$

where $e_3$ is the exponent of the permutation matrix which multiplies the matrixes represented by all the elements in the third row of the table of Figure 2. This multiplication is implemented by performing the following calculation in row 3: (3, $j$) = $\mod\{[e_3 + (3, j)], Z_0\}$ = $\mod\{[59 + (3, j)], 108\}$ where with $j$ =1,2,3,......,90,91 is indicated the column index.

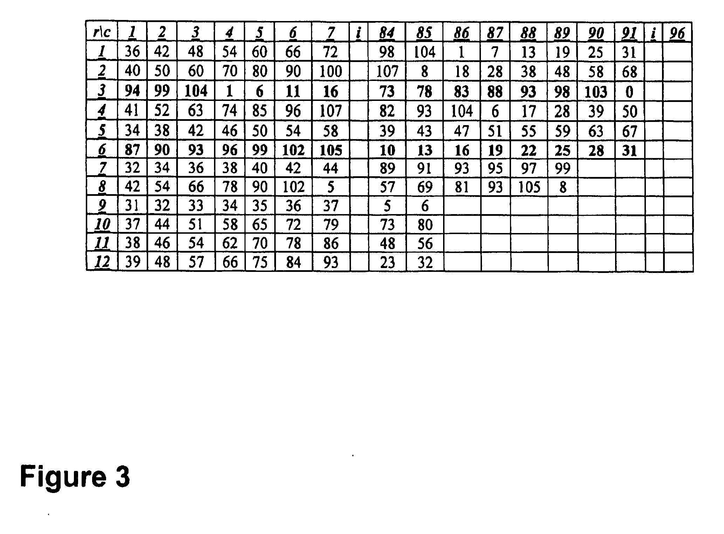

The required processing to be done in the dedicated rows are advantageously simple sum operations on the elements of the exponent matrix as it can be seen by looking at the processed rows represented in bold in the table of Figure 3

The results of these processing steps performed on the random table of Figure 2 produce a single-rate table to carry-out the LDPC code with code-rate $R_2$ =15/16, as shown in the table of Figure 3. Only, the two rows highlighted in bold type have been modified and these two rows are the ones dedicated to the LDPC code with code-rate $R_2$ = 15/16. The single-rate table of Figure 3 is an intermediate step for building the multi-rate table according to the example of the present invention.

### Required extra processing for rate $R_1$

For code rate $R_1$ =11/12, the dedicated exponent matrix for LDPC code has dimensions $r_1 \cdot n_b$ where $r_1 = n_b \cdot$ (1- $R_1$) = 8 and $n_b$ = 96. The semi-deterministic column vector $Cv$ is located at position $c_1$ where $c_1 = n_b - (r_1 -1) = 89$.

Hence, for this LDPC code with rate $R_1$ =11/12, the following two rows are dedicated, the eight row $r_1$ and the fourth row 4, the latter being chosen in a random way among the available rows.

- The eighth row, in mandatory way, the coordinates of the column element being $(r_1, c_1)$ = (8,89)
- The fourth row chosen, in random way, between the second and the seventh rows, excluded the third and sixth row which are already dedicated to the LDPC code with rate $R_2$ =15/16; the coordinates of the column element in the fourth row being $(4, c_1)$ = (4,89)

The above-mentioned two rows, after being modified by the processing described below, belong to the multi-rate exponent table and they cannot be dedicated to the other remaining code rate $R_0$ = 7/8.

In order to satisfy the conditions on the column vector $Cv$ for which element $(r_1, c_1)$ = (8,89) must be equal to element (1, $c_1$) = (1,89), the elements represented by the eight row $r_1$ are multiplied with the permutation matrix of the identity matrix of exponent 11 as shown below:

$$e_8 = \mod\{[(1, c_1) - (r_1, c_1)], Z_0\} = \mod\{[19 - 8], 108\} = 11$$

 $e_8$ is the exponent of the permutation matrix which multiplies, in the table of Figure 3, the matrixes represented by all the elements of the dedicated row $r_1$ = 8 . This multiplication is implemented by performing the following calculation in row $r_1$ = 8 : $(r_1, j)$ = $\mod\{[e_8 + (r_1, j)], Z_0\}$ = $\mod\{[11 + (r_1, j)], 108\}$ with $j$ =1,2,3,......,88,89 column number

[0069]    In order to impose the condition of having the element (4, $c_1$) = (4,89) equal to zero (identity matrix), the elements represented by the forth row are multiplied by the permutation matrix of the identity matrix of exponent 80 as shown below:

$$e_4 = \mod\{[0 - (4, c_1)], Z_0\} = \mod\{[0 - 28], 108\} = 80$$

where $e_4$ is the exponent of the permutation matrix which multiplies the matrixes represented by all the elements of the fourth row of the table of Figure 3. This multiplication is implemented by performing the following calculation in row 4: (4, $j$) = $\mod\{[e_4 + (4, j)], Z_0\}$ = $\mod\{[80 + (4, j)], 108\}$ with $j$ =1,2,3,......,88,89 column number

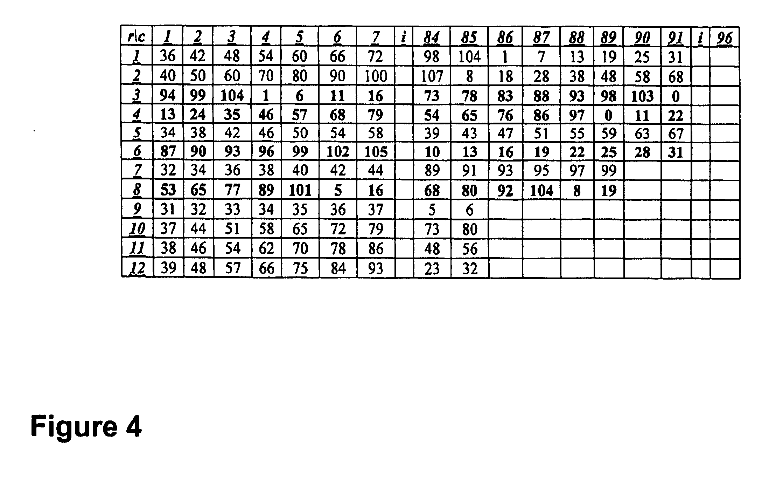

[0070]    Thus, the table of Figure 3 is accordingly modified to obtain the table of Figure 4, which is the bi-rate table to carry-out the LDPC codes with rates $R_2$ = 15116 and $R_1$ =11/12.

*__Required extra processing for rate $R_0$__*

For this numerical example, the last required processing for generating a multi-rate table is to modify two more rows for rate $R_0=7/8$ as illustrated below.

The exponent matrix for LDPC code with rate $R_0=7/8$ has dimensions $r_0 \cdot n_b$ where $r_0 = n_b \cdot (1- R_0) =12$. The semi-deterministic column vector $Cv$ is located at position $c_0$ where $c_0 = n_b - (r_0 -1) = 85$

Hence, for this LDPC code with rate $R_0=7/8$, the following two rows are dedicated, the twelfth row $r_0$ and the ninth row 9, the latter being chosen in a random way among the available rows.

- The twelfth row, in mandatory way; the coordinates of the column element being $(r_0, c_0) = (12,85)$
- The ninth row chosen, in random way, between the second and the eleventh rows, excluded the ones already used for the previous code rates; the coordinates of the column element in the ninth row being $(9,c_0)=(9,85)$.

In order to satisfy the condition on the column vector $Cv$ for which element $(r_0,c_0) = (12,85)$ must be equal to element $(1,c_0) = (1,85)$, the elements represented by the twelfth row $r_0$ are multiplied with the permutation matrix of the identity matrix of exponent 72 as shown below:

$$e_{12} = \mathrm{mod}\left\{[(1,c_0) - (r_0,c_0)], Z_0\right\} = \mathrm{mod}\left\{[104 - 32], 108\right\} = 72$$

The matrixes represented by all the elements in the dedicated row $r_0 =12$ of Figure 4 are multiplied with the permutation matrix of exponent $e_{12}$. This multiplication is implemented by performing the following calculation on row $r_0 =12$ of the table of Figure 4:

$$(r_0, j) = \mathrm{mod}\left\{[e_{12} + (r_0, j)], Z_0\right\} = \mathrm{mod}\left\{[72 + (r_0, j)], 108\right\} \quad \text{with } j = 1,2,3,\ldots,84,85$$

In order to impose the condition of having the element $(9,c_0) = (9,85)$ equal to zero (identity matrix), the matrixes represented by the elements of the ninth row are multiplied by the permutation matrix of the identity matrix of exponent 102 as shown below:

$$e_9 = \mathrm{mod}\left\{[0 - (9,c_0)], Z_0\right\} = \mathrm{mod}\left\{[0 - 6], 108\right\} = 102$$

This multiplication is implemented by performing the following calculation on row 9 of the table of Figure 4:

$$(9, j) = \mathrm{mod}\left\{[e_9 + (9, j)], Z_0\right\} = \mathrm{mod}\left\{[102 + (9, j)], 108\right\} \quad \text{with } j = 1,2,3,\ldots,84,85$$

This last processing steps, performed on the bi-rate table of Figure 4, produce the desired multi-rate exponent table of Figure 5, for the LDPC code with rates $R_2 = 15/16$, $R_1 =11/12$ and . $R_0 = 7/8$

As it is shown in the above example, for each code rate $R_2, R_1, R_0,$ two rows are dedicated and are processed with an opportune operation as generally shown in relations (3b) and (4b). These processed rows cannot be dedicated to other code rates but still belong to the exponent matrixes built also for these other code rates. For example, the two rows dedicated to the code rate $R_2,$ cannot be dedicated and processed for code other rates but still belong to the multi-rate exponent table for rates $R_2, R_1, R_0.$

*__Example of deriving the exponent matrix for rate $R_2$ departing from the multi-rate table__*

The process of deriving the exponent matrix for a given rate from the multi-rate table, according to this example embodiment of the present invention, is illustrated in the example below for code rate $R_2 = 15/16$.

The exponent matrix for code rate $R_2$ = 15/16 is derived from the multi-rate table of Figure 5 by performing the following steps:

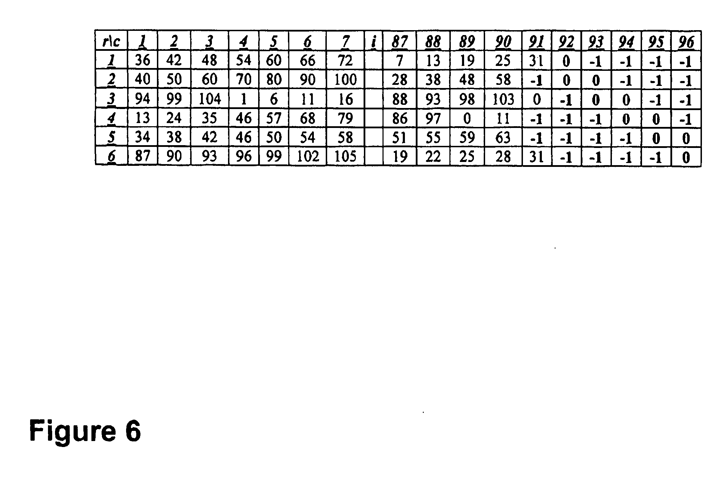

- eliminating the $r_0$ - $r_2$ = 12 - 6 = 6 rows of higher index;
- setting the elements of the semi-deterministic matrix equal to the dual diagonal matrix excluded the three fixed element of the column vector $Cv$ as highlighted in bold type in the table of Figure 6.

The table of Figure 6 shows the exponent matrix $H_{6x96}^{exp}$ for LDPC code with rate $R_2$ =15/16 derived from the multi-rate table of Figure 5.

Similarly, the other exponent matrixes for code rates $R_1$, $R_0$ can be derived from the multi-rate table of Figure 5 by eliminating the opportune number of rows and by setting in an opportune manner the values of the semi-deterministic matrix.

### _Deriving the expanded parity check matrix as known from the art_

For completeness purposes, here-below it is shortly outlined the required processing for deriving the parity check expanded matrix $H_{rxn}^{LDPC}$ for LPDC code as known from the art, departing from the exponent matrix $H_{6x96}^{exp}$ for code rate $R_2$ =15/16 of Figure 6.

The block structured exponent matrix $E_{6x96}^{LDPC}$ for LDPC code - before expansion - is obtained by multiplicating element-by-element, with the (.*) operator, the "seed" matrix $H_{6x96}^{seed}$ with the above exponent matrix $H_{6x96}^{exp}$ as shown in the below equation:

$$E_{6x96}^{LDPC} = H_{6x96}^{seed}(.*)H_{6x96}^{exp} \qquad\qquad (5)$$

The seed matrix is a binary matrix, dedicated for each code rate, with elements having the following meaning:

- if the seed matrix element has value "I", the corresponding exponent matrix element $H_{6x96}^{exp}$ is carried unchanged into the corresponding element of the LDPC exponent matrix $E_{6x96}^{LDPC}$
- if the seed matrix element has value 0, for convention, the value "-1" is carried into the corresponding element of the LDPC exponent matrix $E_{6x96}^{LDPC}$.

It is noted that given the conventional meaning of the "0" value element in the seed matrix, in other embodiments of the present invention, the deterministic elements of the semi-deterministic vector $Cv$ can be set to any value if the corresponding seed matrix elements are set to value "0".

Let us assume that the maximum codeword size is to be implemented, then the maximum spreading factor $Z_0$ has to be used in the expansion procedure. The parity check expanded matrix $H_{rxn}^{LDPC}$ of the LDPC code is obtained by means of the spreading of all elements of exponent matrix $E_{6x96}^{LDPC}$; the dimensions of the LDPC expanded matrix are $rxn$ where $n = n_b \cdot Z_0 = n_0$ =10368 and $r = r_2 \cdot Z_0$ = 648

$$H_{rxn}^{LDPC} = E_{6x96}^{LDPC}\Big|_{spread\_Z_0 x Z_0} \qquad\qquad (6)$$

In the expanded matrix $H_{rxn}^{LDPC}$, for each $E_{6x96}^{LDPC}$ element of value different of "- 1 ", an identity matrix permutation matrix is generated while for each $E_{6x96}^{LDPC}$ element equal to "-1" a square null matrix, of spreading factor dimensions, is generated.

*Storage requirements - comparative analysis*

The proposed invention allows reducing the cost of channel encoder/decoder equipments because it is possible to store only one multi-rate exponent table from which several exponent matrixes $H^{exp}$ can be derived.

Each exponent of the multi-rate exponent table can reach values from *0* to ($Z_0$ -1) where $Z_0$ is the maximum spreading factor. In our LDPC code implementation we have dedicated 8-bits for the maximum spreading factor $Z_0$. In other embodiments of the present invention another number of bits may be used for the maximum spreading factor $Z_0$

Here below follows a comparative analysis between the storage requirements of the LDPC code carried out according to an example embodiment of the present invention and the storage requirements of the equivalent LDPC code, carried-out according to the standard *IEEE 802.16e* [Ref. 1].

In this example the following LDPC code is considered:

Spreading factors: $Z_f$= 54, 81, 108
Block_size (codeword length) =5184 (54*96), 7776 (81*96), 10368 (108*96)
Rate = 1/2, 2/3, 3/4, 5/6, 7/8, 11/12, 15/16

The storage requirements for the multi-rate exponent table according to this example of the present invention is determined by storage requirement of the highest LDPC code rate exponent matrix $R_6$ = 15/16, size 6x91, adding as many rows as necessary, computed as shown below, to reach the next code rate $R_5$ =11/12, size 2x89, and so on to reach the code rate $R_0$ =1/2

$$r_6 = n_b \cdot (1 - R_6) = 6$$

$$r_5 - r_6 = n_b \cdot (R_6 - R_5) = 2$$

$$r_4 - r_5 = n_b \cdot (R_5 - R_4) = 4$$

$$r_i - r_{i+1} = n_b \cdot (R_{i+1} - R_i)$$

$$r_0 - r_1 = n_b \cdot (R_1 - R_0) = 16$$

These storage requirements are computed by adding all the contributions of the second column of Table 2 below.

Since for each code rate only two rows of the parity-check matrix $H^{exp}$ are dedicated, in this implementation it is possible to carry-out until 22 code rates as shown below.

$$\frac{r_0 - r_6}{2} + 1 = \frac{n_b}{2} \cdot (R_6 - R_0) + 1 = 22$$

According to standard *IEEE 802.1 6e* [1] for the LDPC code, it is necessary to store as many dedicated exponent matrixes as many are the code rates $R_j$. These requirements are computed by adding all the contributions of the third column of Table 2 below.

Table 2

| LDPC code rate | NSN multi_rate exponent matrix rows·columns-bit_number (Z0) | IEEE 802.16e exponent matrix rows·columns·bit_number (Z0) |
|---|---|---|
| | | |
| $R_6$ =15/16 | 6·91·8 = 4368-bits | 6·91·8 = 4368-bits |

(continued)

| LDPC code rate | NSN multi_rate exponent matrix rows·columns-bit_number (Z0) | IEEE 802.16e exponent matrix rows·columns·bit_number (Z0) |
|---|---|---|
| $R_5 = 11/12$ | 2·89·8 = 1424-bits | 8·89·8 = 5696-bits |
| $R_4 = 7/8$ | 4·85·8 = 2720-bits | 12·85·8 = 8160-bits |
| $R_3 = 5/6$ | 4·81·8 = 2592-bits | 16·81·8 = 10368-bits |
| $R_2 = 3/4$ | 8·73·8 = 4672-bits | 24·73·8 = 14016-bits |
| $R_1 = 2/3$ | 8·65·8 = 4160-bits | 32·65·8 = 16640-bits |
| $R_0 = 1/2$ | 16·49·8 = 6272-bits | 48·49·8 = 18816-bits |

Table 2 compares the storage requirements for an example of multi-rate table according to the present invention and for the Standard IEEE 802.16e [Ref.1 ] LDPC code exponent matrix.

It is noted that in the computation of the storage requirement only the random part of the exponent matrix has been considered and the semi-deterministic column vector, since the dimension of the deterministic part is the same for both cases.

Thus, the storage requirement of this invention example is 26208-bits while the storage requirement of IEEE standard [Ref.1] is 78064-bits.

The LDPC code according to the present invention requires the storage, for each code rate $R_j$, except the first one ($R_6 = 15/16$), of a row number equal to the difference between the processed code rate and the code rate immediately higher than it.

$$r_6 = n_b \cdot (1 - R_6) = 6 \quad \Rightarrow \quad r_6 \cdot (n_b - r_6 + 1) \cdot bit\_number(Z_0) = 6 \cdot 91 \cdot 8 = 4368\_bits$$

$$r_5 = n_b \cdot (1 - R_5) = 8 \quad \Rightarrow \quad (r_5 - r_6) \cdot (n_b - r_5 + 1) \cdot bit\_number(Z_0) = 2 \cdot 89 \cdot 8 = 1424\_bits$$

$$r_i = n_b \cdot (1 - R_i) \quad \Rightarrow \quad (r_i - r_{i+1}) \cdot (n_b - r_i + 1) \cdot bit\_number(Z_0)$$

$$r_0 = n_b \cdot (1 - R_0) = 48 \quad \Rightarrow \quad (r_0 - r_1) \cdot (n_b - r_0 + 1) \cdot bit\_number(Z_0) = 16 \cdot 49 \cdot 8 = 6272\_bits$$

Instead, the LDPC code according to the standard IEEE 802.16e [Ref.1] requires the storage of the overall exponent matrix for each code rate.

$$r_6 = n_b \cdot (1 - R_6) = 6 \quad \Rightarrow \quad r_6 \cdot (n_b - r_6 + 1) \cdot bit\_number(Z_0) = 6 \cdot 91 \cdot 8 = 4368\_bits$$

$$r_5 = n_b \cdot (1 - R_5) = 8 \quad \Rightarrow \quad r_5 \cdot (n_b - r_5 + 1) \cdot bit\_number(Z_0) = 8 \cdot 89 \cdot 8 = 5696\_bits$$

$$r_i = n_b \cdot (1 - R_i) \quad \Rightarrow \quad r_i \cdot (n_b - r_i + 1) \cdot bit\_number(Z_0)$$

$$r_0 = n_b \cdot (1 - R_0) = 48 \quad \Rightarrow \quad r_0 \cdot (n_b - r_0 + 1) \cdot bit\_number(Z_0) = 48 \cdot 49 \cdot 8 = 18816\_bits$$

The above equations can be generalized in the following way and the factor *bit_number(Z0) is* for the moment disregarded, being it a multiplication factor:

$$Multirate\_storage = r_i \cdot (n_b - r_i + 1) + (r_{i-1} - r_i) \cdot (n_b - r_{i-1} + 1) + ... + (r_0 - r_1) \cdot (n_b - r_0 + 1)$$

$$IEEE\_storage = r_i \cdot (n_b - r_i + 1) + r_{i-1} \cdot (n_b - r_{i-1} + 1) + ... + r_0 \cdot (n_b - r_0 + 1)$$

where *i* is the code rate highest index, in our example *i* = 6.
The storage requirement difference, between the multirate code according to the present invention and the LDPC code according to the IEEE 802.16e standard [Ref.1], is computed with this relation

$$\Delta\_storage = IEEE\_storage - Multirate\_storage =$$
$$= (r_i + r_{i-1} + r_{i-2} + ... + r_2 + r_1) \cdot (n_b + 1) + \qquad (7)$$
$$- (r_i \cdot r_{i-1} + r_{i-1} \cdot r_{i-2} + ... + r_2 \cdot r_1 + r_1 \cdot r_0)$$

From equation (7), it is easy to compute the storage reductions $\Delta\_storage$, $\Delta\_bits$ gained with the example of the proposed invention.
For this example, where *i* = 6 then the equation (7) becomes

$$\Delta\_storage = IEEE\_storage - NSN\_storage =$$
$$= (r_6 + r_5 + r_4 + r_3 + r_2 + r_1) \cdot (n_b + 1) +$$
$$- (r_6 \cdot r_5 + r_5 \cdot r_4 + r_4 \cdot r_3 + r_3 \cdot r_2 + r_2 \cdot r_1 + r_1 \cdot r_0)$$

$$\Delta\_storage = (6 + 8 + ... + 24 + 32) \cdot (96 + 1) - (6 \cdot 8 + 8 \cdot 12 + ... + 24 \cdot 32 + 32 \cdot 48) = 6482$$

Finally, in order to obtain the storage difference in terms of bits, the memory location number $\Delta\_storage$ is multiplied with the bit number of the highest spreading factor $Z_0$ $bit\_number(Z_0)$.

$$\Delta\_bits = (\Delta\_storage) \cdot (bit\_number(Z_0)) = 51856 \text{ bits}$$

As a final check, the obtained value 51856 bits for $\Delta\_bits$ corresponds to the difference between the two above mentioned total contributions 78064 bits and 26208 bits.
It is noted that in the computation of the storage requirements for the LDPC codes according to the present invention, for simplicity reasons, the contribution of the seed matrixes have been neglected being these matrixes binary ones having therefore small storage requirements.
Since LDPC codes implemented with semi-random technique may be used in a large variety of transmission channels, the embodiments of the proposed invention may be advantageously used in such channels. Examples of these channels include telephone lines, high-frequency radio links, microwave links, satellite links, and telemetry links.
In addition to the embodiments of the present invention described above, the skilled persons in the art will be able to arrive at a variety of other arrangements and steps which, if not explicitly described in this document, nevertheless fall within the scope of the appended claims.

### References

[Ref.1] IEEE 802.16e Standard for Air Interface For Fixed and Mobile Broadband Wireless Access Systems - 28 February 2006

### Used acronyms

LDPC Low Density Parity Check

### Claims

1. A method of encoding/decoding information sequences of $k$ bits using a multi-rate exponent table of dimension $n_b x r_b$ for generating exponent matrixes for LDPC codes of different rates $R_j$ with $R_j \geq 1 - r_b / n_b$, the exponents representing permutation matrixes of the identity matrix with the given exponent, said LDPC codes supporting different block sizes for each code rate $R_j$ and being implemented with semi-random technique which requires that the exponent matrixes are composed of two sub-matrixes, a random sub-matrix and a semi-deterministic sub-matrix, wherein, conditions on column vector Cv, the first column vector of the semi-deterministic sub-matrix, require that said column vector Cv has only three "non-null" elements with value different from "-1", which conventionally represents a null matrix, fulfilling the conditions that two of said three non-null elements being the first and the last element of the column vector Cv are equal and the third non-null element being in a random position and having value "0" which represents the identity matrix,
the method being **characterized in that** it comprises the steps of:

   - providing a random exponent table having a column number $n_b$ and a row number $r_b$, the exponents representing permutation matrixes of the identity matrix with the given exponent;
   - dedicating for each code rate $R_j$, two rows of the random exponent table to be modified by processing whereby said rows, after being modified belong to the multi-rate exponent table;
   - generating the multi-rate exponent table from said random exponent table, by processing, for each code rate $R_j$ the elements of the two dedicated rows so as to satisfy said conditions on said column vector $Cv$.

2. The method according to claim 1, wherein said column number $n_b$ is computed as $n_b = n_0/Z_0$ being $n_0$ the maximum codeword length and being $Z_0$ the corresponding maximum spreading factor.

3. The method according to any of the preceding claims wherein, for each code-rate $R_j$, the choice of the two dedicated rows comprises the following step:

   - choosing the first dedicated row as being row $r_j$ where $r_j$ is computed as $r_j = n_b \cdot (1-R_j)$
   - choosing the second dedicated row randomly among the non-dedicated available rows between the first row and row $r_j$ excluded.

4. The method according to claim 3 wherein the elements of two dedicated rows are processed according to the following steps:

   - adding to each element of the first dedicated row $r_j$ a value so that, after a "mod" operation, the first and the last value of the column vector $Cv$ arc identical
   - adding to the each element of the second dedicated row a value so that, after a "mod" operation, the randomly chosen element in column vector $Cv$ has value "0".

5. A method according to any of the previous claims, additionally comprising the method step of generating an exponent matrix of rate $R_j$ for LDPC codes, departing from the multi-rate exponent table generated with the method according to any of the previous claims, wherein the exponent matrix for code-rate $R_j$ has dimensions $r_j x n_j$ and it is composed of two sub-matrixes, a random sub-matrix of dimensions $r_j \cdot (r_j - r_j)$ and a semi-deterministic sub-matrix of dimensions $r_j x r_j$ wherein:

- the random sub-matrix is generated by removing from the multi-rate exponent table the rows with index higher that $r_j$ and the columns with index higher than $(n_j\ r_j)$;
- the first column vector $Cv$ of the semi-deterministic matrix being located at column $(n_j\text{-}r_j\text{+}1)$ of the multi-rate exponent table, has three elements with value different than"-1", the first element and the two elements of the two dedicated rows for rate $R_j$.

6. The method according to claim 5, wherein the row number $r_j$ and the column number $n_j$ of the exponent matrix for code-rate $R_j$ are computed as follows: $r_j=n_b(1-R_j)$ and $n_j=n_b$

7. A system having means for performing the steps of the method according to any of the preceding claims.

**Patentansprüche**

1. Verfahren zum Codieren/Decodieren von Informationsabfolgen von $k$ Bit unter Verwendung einer Multiraten-Exponententabelle der Dimension $n_b \times r_b$ zur Erzeugung von Exponentenmatrizen für LDPC-Codes unterschiedlicher Raten $R_j$ mit
   $R_j \geq 1-r_b/n_b$, wobei die Exponenten Permutationsmatrizen der Einheitsmatrix mit dem gegebenen Exponenten darstellen, wobei die LDPC-Codes unterschiedliche Blockgrößen für jede Code-Rate $R_j$ unterstützen und mit der Semi-Zufallstechnik implementiert werden, die es erforderlich macht, dass die Exponentenmatrizen aus zwei Untermatrizen, einer Zufalls-Untermatrix und einer semi-deterministischen Untermatrix, zusammengesetzt sind, wobei die Bedingungen für den Spaltenvektor Cv, den ersten Spaltenvektor der semi-deterministischen Untermatrix, verlangen, dass der Spaltenvektor $Cv$ nur drei "Nicht-Null"-Elemente mit einem Wert aufweist, der sich von "-1" unterscheidet, welcher üblicherweise eine Nullmatrix darstellt, wobei die Bedingungen erfüllt werden, dass zwei von den drei Nicht-Null-Elementen, die das erste und das letzte Element des Spaltenvektors $Cv$ sind, gleich sind und das dritte Nicht-Null-Element in einer zufälligen Position ist und den Wert "0" aufweist, der die Einheitsmatrix darstellt, wobei das Verfahren **dadurch gekennzeichnet ist, dass** es die falgenden Schritte aufweist:

   - Bereitstellen einer Zufallsexponententabelle, die eine Spaltenanzahl $n_b$ und eine Zeilenanzahl $r_b$ aufweist, wobei die Exponenten Permutationsmatrizen der Einheitsmatrix mit dem gegebenen Exponenten darstellen,
   - für jede Code-Rate $R_j$ zwei Zeilen der Zufallsexponententabelle dafür vorsehen, durch Bearbeiten verändert zu werden, wodurch die Zeilen nach erfolgter Veränderung zur Multiraten-Exponententabelle gehören,
   - Erzeugen der Multiraten-Exponententabelle aus der Zufallsexponententabelle, indem die Elemente der zwei dafür vorgesehenen Zeilen für jede Code-Rate $R_j$ bearbeitet werden, um die Bedingungen für den Spaltenvektor $Cv$ zu erfüllen.

2. Verfahren nach Anspruch 1, wobei die Spaltenanzahl $n_b$ berechnet wird aus $n_b = n_0/Z_0$, wobei $n_0$ die maximale Codewortlänge und $Z_0$ der zugehörige maximale Spreizungsfaktor ist.

3. Verfahren nach einem der vorhergehenden Ansprüche, wobei die Wahl der zwei vorgesehenen Zeilen für jede Code-Rate $R_j$ den folgenden Schritt aufweist:

   - Auswählen der ersten vorgesehenen Zeile derart, dass sie die Zeile $r_j$ ist, wobei $r_j$ berechnet wird als $r_j = n_b(1-R_j)$,
   - zufälliges Auswählen der zweiten vorgesehenen Zeile unter den nicht vorgesehenen verfügbaren Zeilen zwischen der ersten Zeile und der Zeile $r_j$, die ausgenommen ist.

4. Verfahren nach Anspruch 3, wobei die Elemente der zwei vorgesehenen Zeilen bearbeitet werden entsprechend den folgenden Schritten:

   - Hinzufügen eines Wertes zu jedem Element der ersten vorgesehenen Zeile $r_j$ derart, dass nach einer "mod"-Operation der erste und der letzte Wert des Spaltenvektors $Cv$ identisch sind,
   - Hinzufügen eines Wertes zu jedem Element der zweiten vorgesehenen Zeile derart, dass nach einer "mod"-Operation das zufällig ausgewählte Element im Spaltenvektor $Cv$ den Wert "0" aufweist.

5. Verfahren nach einem der vorhergehenden Ansprüche, das zusätzlich den Verfahrensschritt zur Erzeugung einer Exponentenmatrix der Rate $R_j$ für LDPC-Codes aufweist, die von der Multiraten-Exponententabelle abweicht, die mit dem Verfahren nach einem der vorhergehenden Ansprüche erzeugt wurde, wobei die Exponentenmatrix für die Code-Rate $R_j$ Dimensionen $r_j \times n_j$ aufweist und aus zwei Untermatrizen zusammengesetzt ist, einer Zufalls-Unter-

matrix der Dimensionen $r_j \cdot (n_j\text{-}r_j)$ und einer semi-deterministischen Untermatrix der Dimensionen $r_j x r_j$, wobei:

- die Zufalls-Untermatrix erzeugt wird, indem aus der Multiraten-Exponententabelle die Zeilen mit einem Index größer als $r_j$ und die Spalten mit einem Index größer als $(n_j\text{-}r_j)$ entfernt werden,
- der erste Spaltenvektor $Cv$ der semi-deterministischen Matrix, der an der Spalte $(n_j\text{-}r_j+1)$ der Multiraten-Exponententabelle angeordnet ist, drei Elemente, das erste Element und die zwei Elemente der zwei vorgesehenen Zeilen für die Rate $R_j$, mit einem Wert aufweist, der sich von "-1" unterscheidet.

6. Verfahren nach Anspruch 5, wobei die Zeilenanzahl $r_j$ und die Spaltenanzahl $n_j$ der Exponentenmatrix für die Code-Rate $R_j$ wie folgt berechnet werden:

$$r_j = n_b \ (1\text{-}R_j) \ \text{und} \ n_j = n_b.$$

7. System, das Mittel zum Ausführen der Schritte des Verfahrens nach einem der vorhergehenden Ansprüche aufweist.

**Revendications**

1. Un procédé de codage/décodage de séquences d'information de $k$ bits au moyen d'une table d'exposants multi-débit de dimensions $n_b \times r_b$ destiné à générer des matrices d'exposants pour des codes LDPC de débits différents $R_j$ avec $R_j \geq 1 - r_b / n_b$, les exposants représentant des matrices de permutation de la matrice d'identité avec l'exposant donné, lesdits codes LDPC prenant en charge des tailles de bloc différentes pour chaque débit de code $R_j$ et étant mis en oeuvre avec une technique semi-aléatoire qui exige que les matrices d'exposants soient composées de deux sous-matrices, une sous-matrice aléatoire et une sous-matrice semi-déterministe, dans lesquelles des conditions sur le vecteur de colonne Cv, le premier vecteur de colonne de la sous-matrice semi-déterministe, exigent que ledit vecteur de colonne Cv ne possède que trois éléments "non nuls" avec une valeur différente de "-1", qui, par convention, représente une matrice nulle, remplissant les conditions selon lesquelles deux desdits trois éléments non nuls, qui sont le premier et le dernier élément du vecteur de colonne Cv, sont égaux et le troisième élément non nul étant dans une position aléatoire et possédant la valeur "0" qui représente la matrice d'identité, le procédé étant **caractérisé en ce qu'**il comprend les opérations suivantes :

- la fourniture d'une table d'exposants aléatoire possédant un nombre de colonnes $n_b$ et un nombre de lignes $r_b$, les exposants représentant des matrices de permutation de la matrice d'identité avec l'exposant donné,
- la désignation, pour chaque débit de code $R_j$, de deux lignes de la table d'exposants aléatoire à modifier par traitement, grâce à quoi lesdites lignes, après modification, appartiennent à la table d'exposants multi-débit,
- la génération de la table d'exposants multi-débit à partir de ladite table d'exposants aléatoire, par traitement, pour chaque débit de code $R_j$, des éléments des deux lignes désignées de façon à satisfaire lesdites conditions sur ledit vecteur de colonne $Cv$.

2. Le procédé selon la revendication 1, dans lequel ledit nombre de colonnes $n_b$ est calculé avec $n_b = n_0 / Z_0$, $n_0$ étant la longueur de mot de code maximale et $Z_0$ étant le facteur d'étalement maximal correspondant.

3. Le procédé selon l'une quelconque des revendications précédentes dans lequel, pour chaque débit de code $R_j$, le choix des deux lignes désignées comprend l'opération suivants :

- le choix de la première ligne désignée comme étant la ligne $r_j$ où $r_j$ est calculé avec $r_j - n_b \cdot (1\text{-}R_j)$
- le choix de la deuxième ligne désignée de manière aléatoire parmi les lignes non désignées disponibles, la première et la ligne $r_j$ étant exclues.

4. Le procédé selon la revendication 3 dans lequel les éléments de deux lignes désignées sont traités selon les opérations suivantes :

- l'ajout à chaque élément de la première ligne désignée $r_j$ d'une valeur de sorte que, après une opération "mod", la première et la dernière valeur du vecteur de colonne Cv soient identiques,
- l'ajout à chaque élément de la deuxième ligne désignée d'une valeur de sorte que, après une opération "mod", l'élément choisi de manière aléatoire dans le vecteur de colonne Cv ait la valeur "0".

**5.** Un procédé selon l'une quelconque des revendications précédentes comprenant en outre l'opération de procédé de génération d'une matrice d'exposants de débit $R_j$ pour des codes LDPC, s'écartant de la table d'exposants multi-débit générée avec le procédé selon l'une quelconque des revendications précédentes, dans lequel la matrice d'exposants pour le débit de code $R_j$ possède des dimensions $r_j \times n_j$ et est composée de deux sous-matrices, une sous-matrice aléatoire de dimensions $r_j \cdot (n_j - r_j)$ et une sous-matrice semi-déterministe de dimensions $r_j \times r_j$, dans laquelle :

- la sous-matrice aléatoire est générée en retirant de la table d'exposants multi-débit les lignes avec un indice supérieur à $r_j$ et les colonnes avec un indice supérieur à $(n_j - r_j)$,
- le premier vecteur de colonne Cv de la matrice semi-déterministe, situé à la colonne $(n_j - r_j + 1)$ de la table d'exposants multi-débit, possède trois éléments avec une valeur différente de "-1", le premier élément et les deux éléments des deux lignes désignées pour le débit $R_j$.

**6.** Le procédé selon la revendication 5, dans lequel le nombre de lignes $r_j$ et le nombre de colonnes $n_j$ de la matrice d'exposants pour le débit de code $R_j$ sont calculés comme suit :

$r_j = n_b (1 - R_j)$ et $n_j = n_b$.

**7.** Un système muni de moyens d'exécution des opérations du procédé selon l'une quelconque des revendications précédentes.

Fig.1

| r\c | 1 | 2 | 3 | 4 | 5 | 6 | 7 | i | 84 | 85 | 86 | 87 | 88 | 89 | 90 | 91 | i | 96 |
|---|---|---|---|---|---|---|---|---|---|---|---|---|---|---|---|---|---|---|
| 1 | 36 | 42 | 48 | 54 | 60 | 66 | 72 | | 98 | 104 | 1 | 7 | 13 | 19 | 25 | 31 | | |
| 2 | 40 | 50 | 60 | 70 | 80 | 90 | 100 | | 107 | 8 | 18 | 28 | 38 | 48 | 58 | 68 | | |
| 3 | 35 | 40 | 45 | 50 | 55 | 60 | 65 | | 14 | 19 | 24 | 29 | 34 | 39 | 44 | 49 | | |
| 4 | 41 | 52 | 63 | 74 | 85 | 96 | 107 | | 82 | 93 | 104 | 6 | 17 | 28 | 39 | 50 | | |
| 5 | 34 | 38 | 42 | 46 | 50 | 54 | 58 | | 39 | 43 | 47 | 51 | 55 | 59 | 63 | 67 | | |
| 6 | 33 | 36 | 39 | 42 | 45 | 48 | 51 | | 64 | 67 | 70 | 73 | 76 | 79 | 82 | 85 | | |
| 7 | 32 | 34 | 36 | 38 | 40 | 42 | 44 | | 89 | 91 | 93 | 95 | 97 | 99 | | | | |
| 8 | 42 | 54 | 66 | 78 | 90 | 102 | 5 | | 57 | 69 | 81 | 93 | 105 | 8 | | | | |
| 9 | 31 | 32 | 33 | 34 | 35 | 36 | 37 | | 5 | 6 | | | | | | | | |
| 10 | 37 | 44 | 51 | 58 | 65 | 72 | 79 | | 73 | 80 | | | | | | | | |
| 11 | 38 | 46 | 54 | 62 | 70 | 78 | 86 | | 48 | 56 | | | | | | | | |
| 12 | 39 | 48 | 57 | 66 | 75 | 84 | 93 | | 23 | 32 | | | | | | | | |

# Figure 2

| r\c | 1 | 2 | 3 | 4 | 5 | 6 | 7 | i | 84 | 85 | 86 | 87 | 88 | 89 | 90 | 91 | i | 96 |
|---|---|---|---|---|---|---|---|---|---|---|---|---|---|---|---|---|---|---|
| 1 | 36 | 42 | 48 | 54 | 60 | 66 | 72 | | 98 | 104 | 1 | 7 | 13 | 19 | 25 | 31 | | |
| 2 | 40 | 50 | 60 | 70 | 80 | 90 | 100 | | 107 | 8 | 18 | 28 | 38 | 48 | 58 | 68 | | |
| 3 | 94 | 99 | 104 | 1 | 6 | 11 | 16 | | 73 | 78 | 83 | 88 | 93 | 98 | 103 | 0 | | |
| 4 | 41 | 52 | 63 | 74 | 85 | 96 | 107 | | 82 | 93 | 104 | 6 | 17 | 28 | 39 | 50 | | |
| 5 | 34 | 38 | 42 | 46 | 50 | 54 | 58 | | 39 | 43 | 47 | 51 | 55 | 59 | 63 | 67 | | |
| 6 | 87 | 90 | 93 | 96 | 99 | 102 | 105 | | 10 | 13 | 16 | 19 | 22 | 25 | 28 | 31 | | |
| 7 | 32 | 34 | 36 | 38 | 40 | 42 | 44 | | 89 | 91 | 93 | 95 | 97 | 99 | | | | |
| 8 | 42 | 54 | 66 | 78 | 90 | 102 | 5 | | 57 | 69 | 81 | 93 | 105 | 8 | | | | |
| 9 | 31 | 32 | 33 | 34 | 35 | 36 | 37 | | 5 | 6 | | | | | | | | |
| 10 | 37 | 44 | 51 | 58 | 65 | 72 | 79 | | 73 | 80 | | | | | | | | |
| 11 | 38 | 46 | 54 | 62 | 70 | 78 | 86 | | 48 | 56 | | | | | | | | |
| 12 | 39 | 48 | 57 | 66 | 75 | 84 | 93 | | 23 | 32 | | | | | | | | |

Figure 3

| r/c | 1 | 2 | 3 | 4 | 5 | 6 | 7 | i | 84 | 85 | 86 | 87 | 88 | 89 | 90 | 91 | i | 96 |
|---|---|---|---|---|---|---|---|---|---|---|---|---|---|---|---|---|---|---|
| 1 | 36 | 42 | 48 | 54 | 60 | 66 | 72 | | 98 | 104 | 1 | 7 | 13 | 19 | 25 | 31 | | |
| 2 | 40 | 50 | 60 | 70 | 80 | 90 | 100 | | 107 | 8 | 18 | 28 | 38 | 48 | 58 | 68 | | |
| 3 | 94 | 99 | 104 | 1 | 6 | 11 | 16 | | 73 | 78 | 83 | 88 | 93 | 98 | 103 | 0 | | |
| 4 | 13 | 24 | 35 | 46 | 57 | 68 | 79 | | 54 | 65 | 76 | 86 | 97 | 0 | 11 | 22 | | |
| 5 | 34 | 38 | 42 | 46 | 50 | 54 | 58 | | 39 | 43 | 47 | 51 | 55 | 59 | 63 | 67 | | |
| 6 | 87 | 90 | 93 | 96 | 99 | 102 | 105 | | 10 | 13 | 16 | 19 | 22 | 25 | 28 | 31 | | |
| 7 | 32 | 34 | 36 | 38 | 40 | 42 | 44 | | 89 | 91 | 93 | 95 | 97 | 99 | | | | |
| 8 | 53 | 65 | 77 | 89 | 101 | 5 | 16 | | 68 | 80 | 92 | 104 | 8 | 19 | | | | |
| 9 | 31 | 32 | 33 | 34 | 35 | 36 | 37 | | 5 | 6 | | | | | | | | |
| 10 | 37 | 44 | 51 | 58 | 65 | 72 | 79 | | 73 | 80 | | | | | | | | |
| 11 | 38 | 46 | 54 | 62 | 70 | 78 | 86 | | 48 | 56 | | | | | | | | |
| 12 | 39 | 48 | 57 | 66 | 75 | 84 | 93 | | 23 | 32 | | | | | | | | |

Figure 4

| r\c | 1 | 2 | 3 | 4 | 5 | 6 | 7 | i | 84 | 85 | 86 | 87 | 88 | 89 | 90 | 91 | i | 96 |
|---|---|---|---|---|---|---|---|---|---|---|---|---|---|---|---|---|---|---|
| 1 | 36 | 42 | 48 | 54 | 60 | 66 | 72 | . | 98 | 104 | 1 | 7 | 13 | 19 | 25 | 31 | | |
| 2 | 40 | 50 | 60 | 70 | 80 | 90 | 100 | | 107 | 8 | 18 | 28 | 38 | 48 | 58 | 68 | | |
| 3 | 94 | 99 | 104 | 1 | 6 | 11 | 16 | | 73 | 78 | 83 | 88 | 93 | 98 | 103 | 0 | | |
| 4 | 13 | 24 | 35 | 46 | 57 | 68 | 79 | | 54 | 65 | 76 | 86 | 97 | 0 | 11 | 22 | | |
| 5 | 34 | 38 | 42 | 46 | 50 | 54 | 58 | | 39 | 43 | 47 | 51 | 55 | 59 | 63 | 67 | | |
| 6 | 87 | 90 | 93 | 96 | 99 | 102 | 105 | | 10 | 13 | 16 | 19 | 22 | 25 | 28 | 31 | | |
| 7 | 32 | 34 | 36 | 38 | 40 | 42 | 44 | | 89 | 91 | 93 | 95 | 97 | 99 | | | | |
| 8 | 53 | 65 | 77 | 89 | 101 | 5 | 16 | | 68 | 80 | 92 | 104 | 8 | 19 | | | | |
| 9 | 25 | 26 | 27 | 28 | 29 | 30 | 31 | | 107 | 0 | | | | | | | | |
| 10 | 37 | 44 | 51 | 58 | 65 | 72 | 79 | | 73 | 80 | | | | | | | | |
| 11 | 38 | 46 | 54 | 62 | 70 | 78 | 86 | | 48 | 56 | | | | | | | | |
| 12 | 3 | 12 | 21 | 30 | 39 | 48 | 57 | | 95 | 104 | | | | | | | | |

Figure 5

| r\c | 1 | 2 | 3 | 4 | 5 | 6 | 7 | i | 87 | 88 | 89 | 90 | 91 | 92 | 93 | 94 | 95 | 96 |
|---|---|---|---|---|---|---|---|---|---|---|---|---|---|---|---|---|---|---|
| 1 | 36 | 42 | 48 | 54 | 60 | 66 | 72 | | 7 | 13 | 19 | 25 | 31 | 0 | -1 | -1 | -1 | -1 |
| 2 | 40 | 50 | 60 | 70 | 80 | 90 | 100 | | 28 | 38 | 48 | 58 | -1 | 0 | 0 | -1 | -1 | -1 |
| 3 | 94 | 99 | 104 | 1 | 6 | 11 | 16 | | 88 | 93 | 98 | 103 | 0 | -1 | 0 | 0 | -1 | -1 |
| 4 | 13 | 24 | 35 | 46 | 57 | 68 | 79 | | 86 | 97 | 0 | 11 | -1 | -1 | -1 | 0 | 0 | -1 |
| 5 | 34 | 38 | 42 | 46 | 50 | 54 | 58 | | 51 | 55 | 59 | 63 | -1 | -1 | -1 | -1 | 0 | 0 |
| 6 | 87 | 90 | 93 | 96 | 99 | 102 | 105 | | 19 | 22 | 25 | 28 | 31 | -1 | -1 | -1 | -1 | 0 |

# Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2007011569 A1

**Non-patent literature cited in the description**

• *IEEE 802.16e Standard for Air Interface For Fixed and Mobile Broadband Wireless Access Systems,* 28 February 2006